# EUROPEAN PATENT APPLICATION

(11) **EP 4 503 414 A1**
(43) Date of publication of application: **05.02.2025**
(21) Application number: 24190577.7
(22) Date of filing: 24.07.2024
(51) Int. Cl.: H02M 1/00, H02M 1/10, H02M 1/36, H02M 1/42, H02M 3/335, H02M 7/06, G01R 19/02

(54) **POWER-SUPPLY DEVICE**

(30) Priority: 04.08.2023 JP 2023128106
(71) Applicant: Yokogawa Electric Corporation, Tokyo 180-8750 (JP)
(72) Inventor: ISHIZUKA, Ryou, Musashino-shi, Tokyo, 180-8750 (JP); FUKUHARA, Kei, Musashino-shi, Tokyo, 180-8750 (JP); SHIMIZU, Yuusuke, Musashino-shi, Tokyo, 180-8750 (JP)
(74) Representative: Winter, Brandl - Partnerschaft mbB

(57) **Abstract**

A power-supply device 10 includes a pair of input terminals (101,102), a bridge rectification circuit (110), a voltage-dividing circuit (130), an attenuation circuit (140), and a voltage drop detection circuit (170). The input terminals (101,102) are applied with a direct-current input voltage and with an alternating-current input voltage which has the effective value substantially equal to the direct-current input voltage. In the bridge rectification circuit (110), the alternating-current input terminal is connected to the input terminals (101,102) and in which the direct-current output terminal is connected to the input terminal of a load circuit. The voltage-dividing circuit (130) is connected to the input terminals (101,102) and outputs the midpoint voltage of the input voltage. The attenuation circuit (140) outputs a direct-current output voltage obtained by attenuating, to a predetermined ratio, the waveform of the midpoint voltage of the voltage-dividing circuit (130) when the direct-current input voltage is applied to the input terminal, and outputs an alternating-current output voltage obtained by attenuating, to a waveform having the peak voltage substantially equal to the direct-current output voltage, the midpoint voltage of the voltage-dividing circuit (130) when the alternating-current input voltage is applied to the input terminal. The voltage drop detection circuit (170) detects a drop in either the direct-current output voltage or the alternating-voltage output voltage, and accordingly detects a drop in the voltage that is input to the input terminal.

## Description

### FIELD

The application concerned relates to a power-supply device.

### BACKGROUND

A power-supply device is available in which a switching power supply circuit is used. In recent years, in a power-supply device in use, as a result of adapting a switching power supply circuit that is equipped with the power factor improvement function, the input current has a substantially identical waveform to the input voltage. In such a power-supply device, when there is a drop in the input voltage, the input current increases thereby leading to an increase in the loss of the switching transistor in the switching power supply circuit. In that regard, such a power-supply device is proposed in which a power outage detection circuit is installed for detecting a drop in the input voltage on account of power outage and, when there is a drop in the input voltage, control is performed to stop the switching power supply circuit (flyback circuit) (for example, refer to Japanese Patent Application Laid-open No. 2015-042093).

The power outage detection circuit detects power outage based on the peak voltage of the input voltage after full-wave rectification has been performed.

### SUMMARY

However, in the conventional technology mentioned above, when the power-supply device is operated at a direct-current voltage that is equal to the effective value of the alternating-current input voltage, the operating points at the time of detecting a drop in the input voltage are different when the alternating-current input is given than when the direct-current input is given. For that reason, when a direct-current input voltage is applied, the drop in the input voltage is detected at a different voltage than the effective voltage in the case in which an alternating-current input voltage is applied.

It is an objective of the application concerned to provide a power-supply device in which the same detection voltage is used at the time of detecting a drop in the alternating-current input voltage and detecting a drop in the direct-current input voltage.

It is an object of the present invention to at least partially solve the problems in the conventional technology.

A power-supply device according to the present disclosure includes a pair of input terminals, a bridge rectification circuit, a voltage-dividing circuit, an attenuation circuit, and a voltage drop detection circuit. The input terminals are applied with a direct-current input voltage and with an alternating-current input voltage which has the effective value substantially equal to the direct-current input voltage. In the bridge rectification circuit, the alternating-current input terminal is connected to the input terminals and in which the direct-current output terminal is connected to the input terminal of a load circuit. The voltage-dividing circuit is connected to the input terminals and outputs the midpoint voltage of the input voltage. The attenuation circuit outputs a direct-current output voltage obtained by attenuating, to a predetermined ratio, the waveform of the midpoint voltage of the voltage-dividing circuit when the direct-current input voltage is applied to the input terminal, and outputs an alternating-current output voltage obtained by attenuating, to a waveform having the peak voltage substantially equal to the direct-current output voltage, the midpoint voltage of the voltage-dividing circuit when the alternating-current input voltage is applied to the input terminal. The voltage drop detection circuit detects a drop in either the direct-current output voltage or the alternating-voltage output voltage, and accordingly detects a drop in the voltage that is input to the input terminal.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a diagram illustrating an exemplary configuration of a power-supply device according to a first embodiment of the application concerned;
FIG. 2 is a diagram illustrating an exemplary configuration of an attenuation circuit, a voltage drop detection circuit, a peak voltage detection circuit, and a starting-voltage detection circuit according to the first embodiment of the application concerned;
FIG. 3 is a diagram illustrating an example of attenuation of the input voltage according to the embodiment of the application concerned;
FIG. 4 is a diagram illustrating another exemplary configuration of the attenuation circuit and the peak voltage detection circuit according to the first embodiment of the application concerned;
FIG. 5 is a diagram illustrating an exemplary configuration of the power-supply device according to a second embodiment of the application concerned; and
FIG. 6 is a diagram illustrating an exemplary configuration of the attenuation circuit according to a third embodiment of the application concerned.

### DESCRIPTION OF EMBODIMENTS

Exemplary embodiments of the application concerned are described below in detail with reference to the accompanying drawings. The explanation is given in the order given below. Meanwhile, in the embodiments described below, identical constituent elements are referred to by the same reference numerals, and their explanation is not given repeatedly.
1. First embodiment
2. Second embodiment
3. Third embodiment

### 1. First embodiment

### Configuration of power-supply device

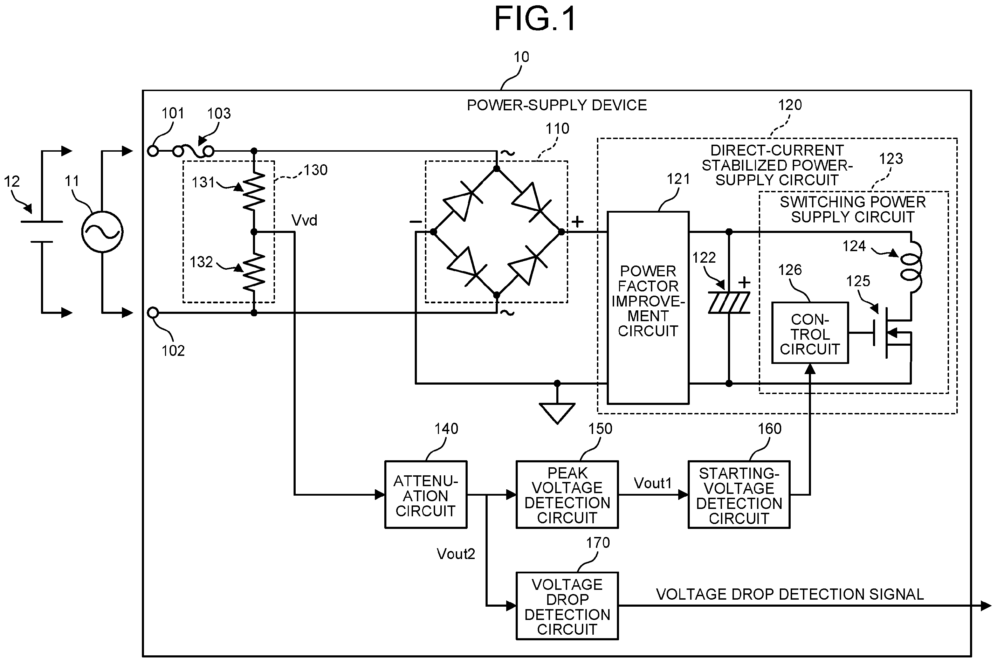

FIG. 1 is a diagram illustrating an exemplary configuration of a power-supply device according to a first embodiment of the application concerned. Herein, FIG. 1 is a circuit diagram illustrating an exemplary configuration of a power-supply device 10. The power-supply device 10 converts the power supply, such as an alternating-current voltage supply or a direct-current voltage supply, into the desired direct-current voltage and supplies that direct-current voltage to other devices. Herein, the alternating-current voltage supply corresponds to, for example, a commercial power supply. In FIG. 1, an alternating-current voltage supply 11 is illustrated. On the other hand, the direct-current voltage supply corresponds to, for example, a battery cell. In FIG. 1, a direct-current voltage supply 12 is illustrated. The direct-current voltage supply 12 outputs a direct-current voltage that is equal to the effective value of the output voltage of the alternating-current voltage supply 11.

The power-supply device 10 includes a pair of input terminals 101 and 102, a bridge rectification circuit 110, a direct-current stabilized power-supply circuit 120, a voltage-dividing circuit 130, an attenuation circuit 140, a voltage drop detection circuit 170, a peak voltage detection circuit 150, and a starting-voltage detection circuit 160.

The input terminals 101 and 102 represent a pair of input terminals to which the alternating-current voltage supply 11 or the direct-current voltage supply 12 is connected.

The bridge rectification circuit 110 performs full-wave rectification of the alternating-current input voltage. Of the bridge rectification circuit 110, the alternating-current input terminals are connected to the input terminals 101 and 102, and the direct-current output terminals are connected to the input terminals of the direct-current stabilized power-supply circuit 120. In the example illustrated in FIG. 1, the bridge rectification circuit 110 is connected to the input terminal 101 via a fuse 103. Moreover, of the bridge rectification circuit 110, the minus terminal among the direct-current output terminals is grounded.

The direct-current stabilized power-supply circuit 120 converts a full-wave rectification waveform, which is output from the bridge rectification circuit 110, into the desired direct-current voltage and supplies that direct-current voltage as the power supply to other devices. The direct-current stabilized power-supply circuit 120 includes a power factor improvement circuit 121, a smoothing capacitor 122, and a switching power supply circuit 123. Meanwhile, the direct-current stabilized power-supply circuit 120 represents an example of a "load circuit" according to the application concerned.

The power factor improvement circuit 121 sets the power factor of the direct-current stabilized power-supply circuit 120 to be substantially equal to "1". The power factor improvement circuit 121 is configured using, for example, a boost chopper circuit, and performs switching of the output voltage of the bridge rectification circuit 110 and converts it into a predetermined direct-current voltage. At that time, the power factor improvement circuit 121 adjusts the switching period to ensure the flow of an input current that has a substantially identical waveform to the input voltage waveform. As a result of installing the power factor improvement circuit 121; the switching power supply circuit 123, which is installed at a subsequent stage, can be maintained to have the same input voltage when the alternating-current voltage supply 11 is connected and when the direct-current voltage supply 12 is connected. As far as the power factor improvement circuit 121 is concerned, it is possible to use a known circuit.

The smoothing capacitor 122 is connected to the output terminal of the power factor improvement circuit 121, and smooths out the output voltage of the power factor improvement circuit 121.

The switching power supply circuit 123 performs switching of the already-smoothed output voltage of the power factor improvement circuit 121 as smoothed out by the smoothing capacitor 122. As far as the switching power supply circuit 123 is concerned, it is possible to use a known circuit. With reference to FIG. 1, the switching power supply circuit 123 is assumed to be a forward circuit or a flyback circuit, and includes a transformer 124, a MOS transistor 125, and a control circuit 126. Herein, regarding the transformer 124, only the primary winding is illustrated. The primary winding of the transformer 124 and the MOS transistor 125, which are connected in series, are connected to the input end of the switching power supply circuit 123.

The MOS transistor 125 performs switching and applies a pulsed alternating-current voltage to the primary winding of the transformer 124. Then, the alternating-current voltage is stepped up or stepped down and the resultant voltage is output from the primary winding. The voltage of the primary winding of the transformer 124 is rectified, smoothed out, and converted into a direct current; and then the direct current is output from the direct-current stabilized power-supply circuit 120. The control circuit 126 controls the on/off ratio of the switching of the MOS transistor 125, and performs control to stabilize the output voltage of the direct-current stabilized power-supply circuit 120. Moreover, the control circuit 126 also performs control to start the switching of the MOS transistor 125 when the voltage applied to the input terminals 101 and 102 reaches a predetermined level. That is, when the voltage applied to the input terminals 101 and 102 is low, the control circuit 126 stops the switching of the MOS transistor 125. Herein, whether or not the voltage applied to the input terminals 101 and 102 has reached a predetermined level is detected by the starting-voltage detection circuit 160. Thus, based on a signal received from the starting-voltage detection circuit 160, the control circuit 126 performs control to stop the switching of the MOS transistor 125.

The voltage-dividing circuit 130 is connected in between the input terminals 101 and 102, and outputs the midpoint voltage of the input voltage. In the example illustrated in FIG. 1, the voltage-dividing circuit 130 is connected to the input terminal 101 via the fuse 103. The voltage-dividing circuit 130 is configured using resistances 131 and 132 that are connected to each other in series. The resistances 131 and 132 can be set to have the same resistance value. The midpoint voltage (Vvd in FIG. 1) is output from the midpoint between the resistances 131 and 132 that are connected to each other in series.

The attenuation circuit 140 outputs a direct-current output voltage that is obtained by attenuating, to a predetermined ratio, the waveform of the midpoint voltage of the voltage-dividing circuit 130 at the time when a direct-current input voltage is input to the input terminals 101 and 102. Moreover, the attenuation circuit 140 also outputs an alternating-current output voltage that is obtained by attenuating, to a waveform having the peak voltage to be substantially equal to the direct-current output voltage, the waveform of the midpoint voltage of the voltage-dividing circuit 130 at the time when an alternating-current input voltage is applied to the input terminals 101 and 102. The output of the attenuation circuit 140 (Vout2 in FIG. 1) is output to the voltage drop detection circuit 170 and the peak voltage detection circuit 150. Regarding the detailed configuration of the attenuation circuit 140, the explanation is given later.

The voltage drop detection circuit 170 detects a drop in either the direct-current output voltage or the alternating-current output voltage received from the attenuation circuit 140, and accordingly detects a drop in the voltage input to the input terminals 101 and 102. Then, the voltage drop detection circuit 170 outputs a voltage drop detection signal, which represents the detection result, to an external device. Regarding the detailed configuration of the voltage drop detection circuit 170, the explanation is given later.

The peak voltage detection circuit 150 detects and outputs the peak voltage of the direct-current output voltage and the peak voltage of the alternating-current output voltage. Then, the peak voltage detection circuit 150 outputs the detected peak voltage (Vout1 in FIG. 1) to the starting-voltage detection circuit 160.

The starting-voltage detection circuit 160 detects an increase in the output voltage of the peak voltage detection circuit 150, and accordingly detects the starting voltage of the switching power supply circuit 123. Then, the detection result is output to the control circuit 126.

### Configuration of attenuation circuit, voltage drop detection circuit, peak voltage detection circuit, and starting-voltage detection circuit

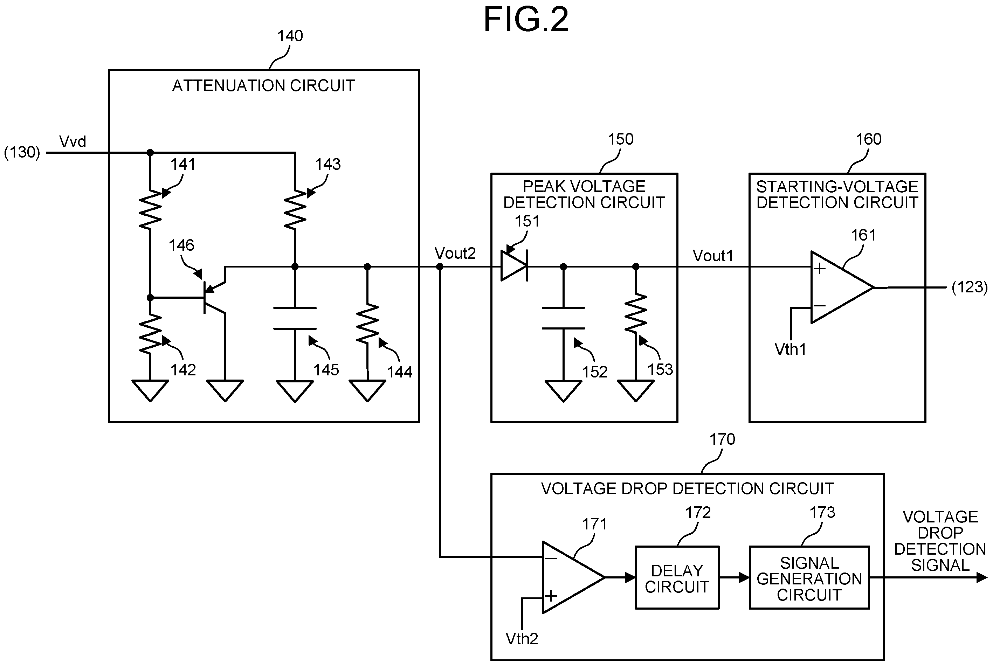

FIG. 2 is a diagram illustrating an exemplary configuration of the attenuation circuit, the voltage drop detection circuit, the peak voltage detection circuit, and the starting-voltage detection circuit according to the first embodiment of the application concerned. Thus, FIG. 2 is a circuit diagram illustrating an exemplary configuration of the attenuation circuit 140, the voltage drop detection circuit 170, the peak voltage detection circuit 150, and the starting-voltage detection circuit 160.

The attenuation circuit 140 includes resistances 141 to 144, a capacitor 145, and a transistor 146. The resistances 141 and 142 that are connected in series are connected in between an input terminal and a grounding wire. A circuit formed by connecting, in series, the capacitor 145, which is connected in parallel to the resistance 143, and the resistance 144 is connected in between the input terminal and the grounding wire. The base of the transistor 146 is connected to the midpoint of the resistances 141 and 142 that are connected in series. The emitter of the transistor 146 is connected to the midpoint of the resistance 143 and the capacitor 145 that are connected in series. The collector of the transistor 146 is grounded. Moreover, the midpoint of the resistance 143 and the capacitor 145, which are connected in series, constitutes the output terminal of the attenuation circuit 140, and Vout2 is output from that output terminal. As far as the transistor 146 is concerned, a pnp transistor can be used.

A circuit formed by connecting, in series, the capacitor 145, which is connected in parallel to the resistance 143, and the resistance 144 is meant for attenuating the input voltage. This circuit is configured using a voltage-dividing circuit in which a plurality of impedance elements including reactance elements is connected in series. As a result of disposing reactance elements in this circuit, it becomes possible to ensure that the attenuation for the direct-current input voltage is different than the attenuation for the alternating-current input voltage.

The circuit of the resistances 141 and 142 and the transistor 146 discharges the voltage of the capacitor 145 when there is a drop in the input voltage (Vvd). As a result of disposing this circuit, a drop in the input voltage can be detected quickly.

The voltage drop detection circuit 170 includes a comparator 171, a delay circuit 172, and a signal generation circuit 173.

The comparator 171 compares the signal output from the attenuation circuit 140 (i.e., compares Vout2) with a threshold voltage Vth2 and, if the output Vout2 is smaller than the threshold value Vth2, outputs an H-level signal.

The delay circuit 172 delays the output signal of the comparator 171. When the alternating-current input voltage approaches 0 V, the delay circuit 172 prevents the detection of a drop in the voltage. Herein, the delay circuit 172 delays the signal, which is output from the comparator 171, by a predetermined period of time. After the delay, if a signal is still output from the comparator 171, then the delay circuit 172 outputs that signal to the signal generation circuit 173.

Based on the output signal of the delay circuit 172, the signal generation circuit 173 generates a voltage drop detection signal and outputs it.

The peak voltage detection circuit 150 includes a diode 151, a capacitor 152, and a resistance 153. The diode 151 has its anode connected to the input terminal and has its cathode connected to the output terminal. The capacitor 152 is connected in between the output terminal and the grounding wire. The resistance 153 is connected in between the output terminal and the grounding wire. Due to the diode 151 and the capacitor 152, the peak voltage of the output (Vout2) of the attenuation circuit 140 is detected. In FIG. 2, Vout1 represents the detected peak voltage. Meanwhile, when the input voltage is not applied, the resistance 153 discharges the capacitor 152.

The starting-voltage detection circuit 160 includes a comparator 161 that compares the signal output from the peak voltage detection circuit 150 (i.e., compares the peak voltage Vout1) with a threshold voltage Vth1 and, if the peak voltage Vout1 is greater than the threshold voltage Vth1, outputs an H-level signal. Then, the H-level signal is transmitted to the control circuit 126.

### Operations of attenuation circuit

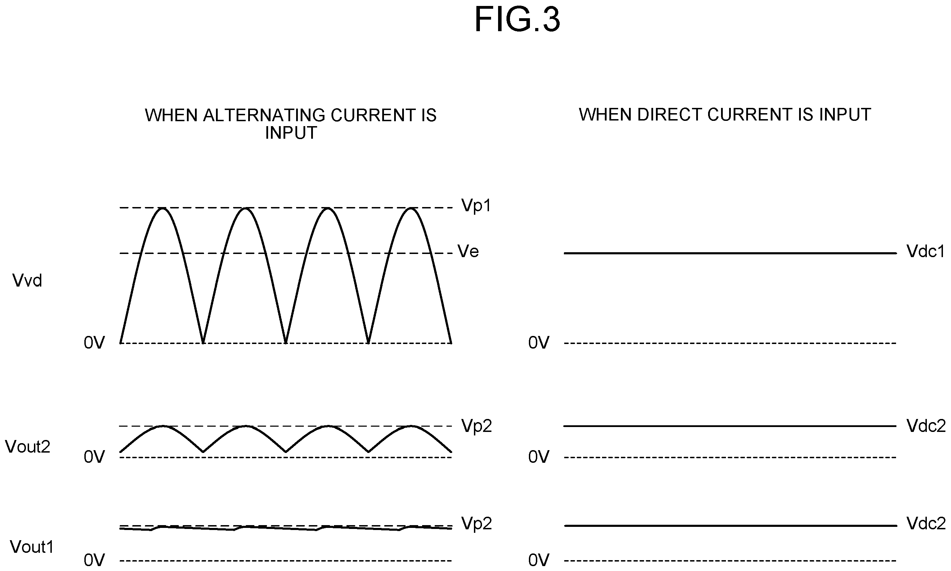

FIG. 3 is a diagram illustrating an example of attenuation of the input voltage according to the embodiment of the application concerned. Thus, FIG. 3 is a diagram illustrating an example of attenuation of the input voltage occurring in the attenuation circuit 140. Thus, the operations of the attenuation circuit 140 and the peak voltage detection circuit 150 are explained with reference to FIG. 3. In FIG. 3, the left side represents the situation when the alternating current is input, and the right side represents the situation when the direct current is input. Moreover, in FIG. 3, "Vvd", "Vout2", and "Vout1" represent the waveforms of Vvd, Vout2, and Vout1, respectively. Meanwhile, in FIG. 3, only an overview of the signal waveforms is illustrated, and those signal waveforms are not necessarily identical to the actual waveforms.

When the direct current is input, Vvd becomes equal to a full-wave rectified waveform. Moreover, in FIG. 3, Vp1 represents the peak voltage and Ve represents the effective voltage. Herein, the voltage waveform is attenuated by the attenuation circuit 140. Moreover, Vout2 represents the post-attenuation waveform, and Vp2 represents the peak voltage of the post-attenuation waveform. Subsequently, the peak voltage is detected by the peak voltage detection circuit 150. Herein, Vout1 represents the detected peak voltage. The waveform of Vout1 is equal to the waveform obtained by smoothing out the waveform of Vout2.

When the direct current is input, Vvd becomes equal to a direct-current waveform. In FIG. 3, Vdc1 represents the direct-current voltage. Herein, Vdc1 is substantially identical to the effective voltage Ve. The direct-current waveform gets attenuated by the attenuation circuit 140 and Vdc2 is obtained as a result. Herein, Vdc2 is substantially same as the peak voltage Vp2. Moreover, the waveform of Vout1 is substantially same as the waveform of Vout2.

Thus, the attenuation circuit 140 performs attenuation in such a way that the peak voltage Vp 1 of the waveform at the time when the alternating current is input becomes equal to the peak voltage Vp2 that is almost equal to the voltage Vdc2 at the time when the direct current is input. As a result, the same voltage Vout2 can be maintained when the alternating current is input and when the direct current is input.

Moreover, as a result of the operations performed by the circuit of the resistances 141 and 142 and the transistor 146 that are disposed in the attenuation circuit 140, when the midpoint voltage Vvd drops to a voltage close to 0 V, the output Vout2 can also be brought down to a voltage close to 0 V. Hence, in the voltage drop detection circuit 170, the detection of a drop in the voltage can be performed quickly.

Meanwhile, consider the case in which the voltage of the capacitor 145 need not be discharged when there is a drop in the midpoint voltage Vvd. For example, consider the case in which the voltage drop detection circuit 170 is omitted. In that case, in the attenuation circuit 140, the circuit of the resistances 141 and 142 and the transistor 146 can be omitted. Thus, the attenuation circuit 140 is configured with the resistances 143 and 144 and the capacitor 145.

### Other configuration of attenuation circuit and peak voltage detection circuit

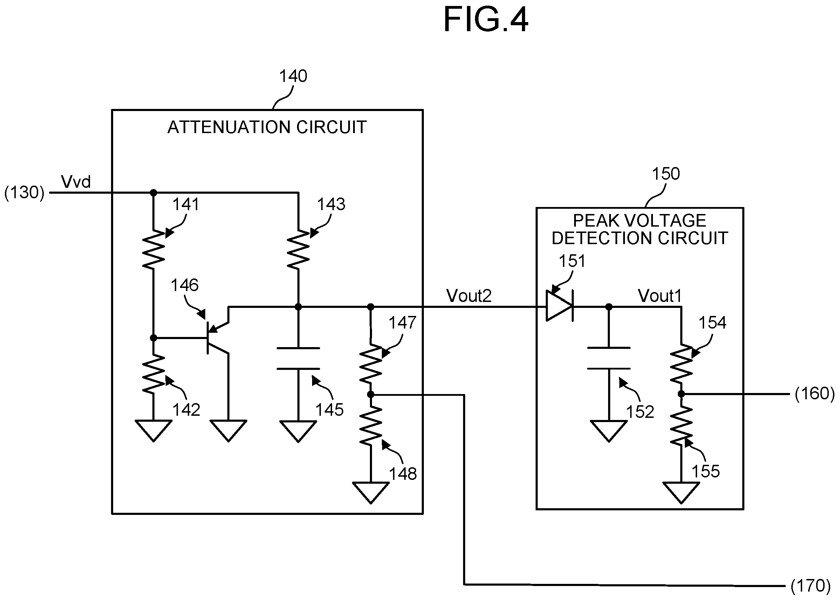

FIG. 4 is a diagram illustrating another exemplary configuration of the attenuation circuit and the peak voltage detection circuit according to the first embodiment of the application concerned. Thus, FIG. 4 is a circuit diagram illustrating another exemplary configuration of the attenuation circuit 140 and the peak voltage detection circuit 150.

With reference to FIG. 4, the attenuation circuit 140 includes resistances 147 and 148, which are connected in series, in place of the resistance 144. The voltage of the midpoint of the resistances 147 and 148, which are connected in series, is output to the voltage drop detection circuit 170. Thus, by adjusting the ratio of the resistances 147 and 148, the voltage to be output to the voltage drop detection circuit 170 can be adjusted.

With reference to FIG. 4, the peak voltage detection circuit 150 includes resistances 154 and 155, which are connected in series, in place of the resistance 153. The voltage of the midpoint of the resistances 154 and 155, which are connected in series, is output to the starting-voltage detection circuit 160. Thus, by adjusting the ratio of the resistances 154 and 155, the voltage to be output to the starting-voltage detection circuit 160 can be adjusted.

In this way, in the power-supply device 10, at the time of detecting a drop in the input voltage, the same detection voltage can be used for the alternating-current input voltage and for the direct-current input voltage.

### 2. Second embodiment

### Configuration of power-supply device

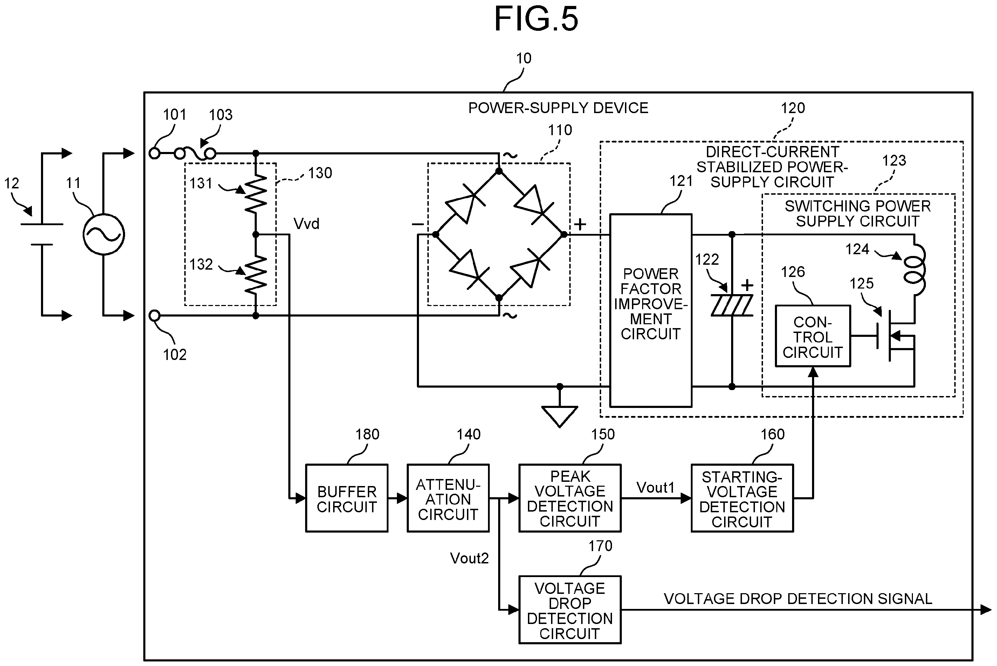

FIG. 5 is a diagram illustrating an exemplary configuration of the power-supply device according to a second embodiment of the application concerned. In an identical manner to FIG. 1, FIG. 5 is a circuit diagram illustrating an exemplary configuration of the power-supply device 10. However, from the power-supply device 10 illustrated in FIG. 1, the power-supply device 10 illustrated in FIG. 5 differs in the way of further including a buffer circuit 180.

The buffer circuit 180 is disposed in between the voltage-dividing circuit 130 and the attenuation circuit 140, and thus separates the voltage-dividing circuit 130 and the attenuation circuit 140. For example, the buffer circuit 180 can be configured using an emitter-follower circuit. As a result of disposing the buffer circuit 180, it becomes possible to reduce the impact of the attenuation circuit 140 on the voltage-dividing circuit 130. On the other hand, when the buffer circuit 180 is not disposed, the attenuation circuit 140 is connected in parallel to either the resistance 131 or the resistance 132 of the voltage-dividing circuit 130, and that leads to an error in the midpoint voltage.

The remaining configuration of the power-supply device 10 is identical to the power-supply device 10 according to the first embodiment of the application concerned. Hence, that explanation is not given again.

In this way, in the power-supply device 10 according to the second embodiment of the application concerned, as a result of disposing the buffer circuit 180, it becomes possible to reduce the variation in the output voltage of the voltage-dividing circuit 130.

### 3. Third embodiment

### Configuration of attenuation circuit

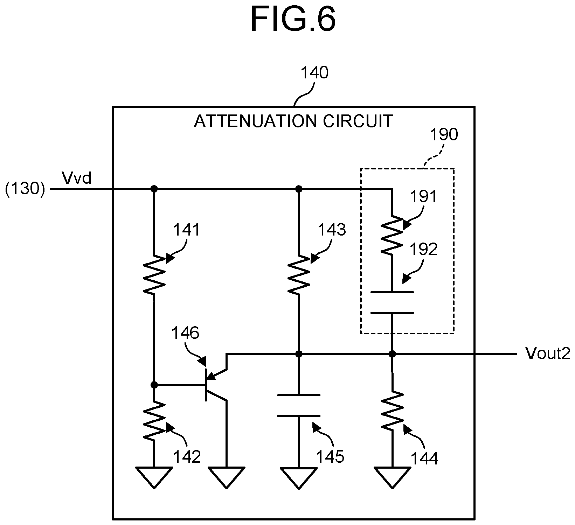

FIG. 6 is a diagram illustrating an exemplary configuration of the attenuation circuit according to a third embodiment of the application concerned. In an identical manner to FIG. 2, FIG. 6 is a circuit diagram illustrating an exemplary configuration of the attenuation circuit 140. From the attenuation circuit 140 illustrated in FIG. 2, the attenuation circuit 140 illustrated in FIG. 6 differs in the way of further including a correction circuit 190.

The correction circuit 190 is configured with a resistance 191 and a capacitor 192 that are connected in series. Moreover, the correction circuit 190 is connected to the resistance 143 in parallel.

With reference to FIG. 6, the resistances 141, 142, 143, and 144 can be set to 100 kΩ, 47 kΩ, 7.8 kΩ, and 10 kΩ, respectively. Moreover, the capacitor 145 can be set to 3.3 µF. At that time, the resistance 191 can be set to 100 Ω. Moreover, the capacitor 192 can be set to 0.47 µF.

The correction circuit 190 adjusts the attenuation of the attenuation circuit 140 according to the frequency of the alternating-current input voltage. As a result of disposing the correction circuit 190, even when the alternating-current input voltage changes from 50 Hz to 60 Hz, the attenuation can be maintained at a constant level.

The attenuation circuit 140 illustrated in FIG. 6 was implemented in the power-supply device 10 illustrated in FIG. 5, and the operations were confirmed by performing simulation. The simulation was performed by setting the value of the gain of the buffer circuit 180 to "1". The following result was obtained.
(1) In response to the application of the direct-current input voltage of 110 V
   Vout1: 18.3 V, Vout2: 18.9 V
(2) In response to the application of the alternating-current input voltage of 110 Vrms (50 Hz)
   Vout1 (peak voltage): 18.8 V, Vout2 (peak voltage): 19.4 V
(3) In response to the application of the alternating-current input voltage of 110 Vrms (60 Hz) was applied
   Vout1 (peak voltage): 18.2 V, Vout2 (peak voltage): 18.7 V

In this way, Vout1 and Vout2 can be maintained to be same in the direct-current input voltage and the alternating-current input voltage. Moreover, even when the alternating-current input voltage changes from 50 Hz to 60 Hz, the variation in Vout1 and Vout2 can be reduced due to the action of the correction circuit 190.

The remaining configuration of the power-supply device 10 is identical to the power-supply device 10 according to the first embodiment of the application concerned. Hence, that explanation is not given again.

In this way, in the power-supply device 10 according to the third embodiment of the application concerned, as a result of disposing the correction circuit 190 in the attenuation circuit 140, even when the frequency of the alternating-current input voltage changes, the attenuation performed by the attenuation circuit 140 can be maintained to a substantially constant level.

Meanwhile, the effects specified in the present written description are only exemplary. Thus, the effects are not limited to the effects specified herein, and it is possible to achieve other effects too.

According to the application concerned, at the time of detecting a drop in the input voltage, the same detection voltage can be used for the alternating-current input voltage and for the direct-current input voltage.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

Exemplary combinations of the technology features disclosed herein are explained below.
(1) A power-supply device comprising:
   a pair of input terminals that are applied with a direct-current input voltage and with an alternating-current input voltage which has effective value substantially equal to the direct-current input voltage;
   a bridge rectification circuit in which alternating-current input terminal is connected to the input terminals and in which direct-current output terminal is connected to input terminal of a load circuit;
   a voltage-dividing circuit that is connected to the input terminals and that outputs midpoint voltage of the input voltage;
   an attenuation circuit that
      outputs a direct-current output voltage obtained by attenuating, to a predetermined ratio, waveform of the midpoint voltage of the voltage-dividing circuit when the direct-current input voltage is applied to the input terminal, and
      outputs an alternating-current output voltage obtained by attenuating, to waveform having peak voltage substantially equal to the direct-current output voltage, the midpoint voltage of the voltage-dividing circuit when the alternating-current input voltage is applied to the input terminal; and
   a voltage drop detection circuit that detects a drop in either the direct-current output voltage or the alternating-voltage output voltage, and accordingly detects a drop in voltage which is input to the input terminal.
(2) The power-supply device according to the above (1), wherein the attenuation circuit is configured using a voltage-dividing circuit in which a plurality of impedance elements is connected in series.
(3) The power-supply device according to the above (1) or (2), further comprising:
   a peak voltage detection circuit that detects peak voltage of the direct-current output voltage and detects peak voltage of the alternating-current output voltage; and
   a starting-voltage detection circuit that detects an increase in output voltage of the peak voltage detection circuit, and accordingly detects starting voltage of the load circuit.
(4) The power-supply device according to any one of the above (1) to (3), further comprising a buffer circuit that is disposed in between the voltage-dividing circuit and the attenuation circuit.
(5) The power-supply device according to any one of the above (1) to (4), further comprising a correction circuit that adjusts output voltage according to frequency of voltage which is input to the input terminal.
(6) The power-supply device according to any one of the above (1) to (5), wherein the load circuit is a direct-current stabilized power-supply circuit.

## Claims

1. A power-supply device comprising:
a pair of input terminals that are applied with a direct-current input voltage and with an alternating-current input voltage which has effective value substantially equal to the direct-current input voltage;
a bridge rectification circuit in which alternating-current input terminal is connected to the input terminals and in which direct-current output terminal is connected to input terminal of a load circuit;
a voltage-dividing circuit that is connected to the input terminals and that outputs midpoint voltage of the input voltage;
an attenuation circuit that
outputs a direct-current output voltage obtained by attenuating, to a predetermined ratio, waveform of the midpoint voltage of the voltage-dividing circuit when the direct-current input voltage is applied to the input terminal, and
outputs an alternating-current output voltage obtained by attenuating, to waveform having peak voltage substantially equal to the direct-current output voltage, the midpoint voltage of the voltage-dividing circuit when the alternating-current input voltage is applied to the input terminal; and
a voltage drop detection circuit that detects a drop in either the direct-current output voltage or the alternating-voltage output voltage, and accordingly detects a drop in voltage which is input to the input terminal.

2. The power-supply device according to claim 1, wherein the attenuation circuit is configured using a voltage-dividing circuit in which a plurality of impedance elements is connected in series.

3. The power-supply device according to claim 1 or 2, further comprising:
a peak voltage detection circuit that detects peak voltage of the direct-current output voltage and detects peak voltage of the alternating-current output voltage; and
a starting-voltage detection circuit that detects an increase in output voltage of the peak voltage detection circuit, and accordingly detects starting voltage of the load circuit.

4. The power-supply device according to any one of claim 1 to 3, further comprising a buffer circuit that is disposed in between the voltage-dividing circuit and the attenuation circuit.

5. The power-supply device according to any one of claim 1 to 4, further comprising a correction circuit that adjusts output voltage according to frequency of voltage which is input to the input terminal.

6. The power-supply device according to any one of claim 1 to 5, wherein the load circuit is a direct-current stabilized power-supply circuit.
